# FASCICULE DE BREVET EUROPEEN

(11) **EP 4 133 532 B1**
(45) Date de publication et mention de la délivrance du brevet: **03.01.2024**
(21) Numéro de dépôt: 21723326.1
(22) Date de dépôt: 02.04.2021
(51) Int. Cl.: H01L 31/0296, H01L 31/103, H01L 31/109, H01L 31/18

(54) **PROCÉDÉ DE FABRICATION D'UN DISPOSITIF DE PHOTODÉTECTION À FAIBLE BRUIT DANS UN SUBSTRAT EN CDHGTE**
VERFAHREN ZUR HERSTELLUNG EINES RAUSCHARMEN PHOTODETEKTORBAUELEMENTS IN EINEM CDHGTE-SUBSTRAT
PROCESS FOR MANUFACTURING A LOW-NOISE PHOTODETECTOR DEVICE IN A CDHGTE SUBSTRATE

(30) Priorité: 09.04.2020 FR 2003595; 25.08.2020 FR 2008678
(43) Date de publication de la demande: 15.02.2023
(73) Titulaire: Commissariat à l'énergie atomique et aux énergies alternatives, 75015 Paris (FR)
(72) Inventeur: BOULARD, François, 38054 GRENOBLE CEDEX 09 (FR); CHAMONAL, Jean-Paul, 38054 GRENOBLE CEDEX 09 (FR); LOBRE, Clément, 38054 Grenoble CEDEX 09 (FR); ROCHETTE, Florent, 38054 Grenoble CEDEX 09 (FR)
(74) Mandataire: Brevalex
(86) Numéro de dépôt international: PCT/FR2021/050587
(87) Numéro de publication internationale: WO 2021/205102

(56) Documents cités:
- EP-A1- 0 541 973
- EP-A1- 2 937 902
- EP-A1- 3 012 876
- WO-A1-2013/079446
- FR-A1- 3 023 976
- FR-A1- 3 042 310

## Description

### Domaine Technique

L'invention concerne le domaine des photodiodes infrarouges en CdₓHg₁₋ₓTe (0<x<1), utilisées pour détecter un rayonnement infrarouge notamment pour des applications en imagerie infrarouge.

### Etat de la technique antérieure

Une photodiode comprend un substrat en matériau semi-conducteur, dans lequel une jonction PN sépare une région dopée N d'une région dopée P. A l'équilibre thermodynamique, une zone de charge d'espace, dépourvue de porteurs libres, s'étend de part et d'autre de la jonction PN et induit un champ électrique intense dans la photodiode.

En fonctionnement, l'une parmi la région dopée N et la région dopée P forme une région d'absorption. Lorsqu'un photon de longueur d'onde adaptée est absorbé dans la région d'absorption, il y créé un porteur dit minoritaire. Ce porteur minoritaire diffuse dans le substrat jusqu'à atteindre la zone de charge d'espace, où il est accéléré par le champ électrique intense vers l'autre région dopée. Sa collection dans cette autre région dopée forme un courant électrique. Une photodiode n'est sensible que dans une gamme de longueurs d'onde déterminée, qui dépend de la largeur de bande interdite, ou gap, dans la région d'absorption. Une faible valeur du gap dans la région d'absorption assure une sensibilité de la photodiode aux grandes longueurs d'onde.

Différents courants «parasites » ou « d'obscurité », liés à l'agitation thermique et à la génération-recombinaison sur des défauts, limitent les performances des photodiodes Positionner la zone de charge de la jonction dans un matériau de plus forte valeur de gap permet de réduire la contribution de ces courants indésirables.

En outre, il est connu que dans un substrat semiconducteur en CdₓHg₁₋ₓTe (alliage de cadmium, mercure et tellure, avec 0<x<1), le gap dépend de la concentration en cadmium. Plus cette concentration est élevée, plus le gap est élevé.

L'homme du métier a donc eu l'idée de réaliser des photodiodes en CdₓHg₁₋ₓTe, avec une région d'absorption à faible teneur en cadmium, pour que la photodiode soit sensible aux grandes longueurs d'onde, et une portion à forte teneur en cadmium dédiée à la réduction du courant d'obscurité. En fonctionnement, au moins une partie de la zone de charge d'espace s'étend dans la portion à forte teneur en cadmium, ce qui permet d'obtenir un courant d'obscurité réduit. Un exemple d'une telle photodiode est décrit dans la demande de brevet WO 2013/079446. Dans ce document, la région d'absorption est dopée N. Un caisson à forte teneur en cadmium s'étend dans la région dopée P, avec une concentration en cadmium sensiblement constante. Le caisson est obtenu en recouvrant un substrat en CdₓHg₁₋ₓTe par une couche riche en cadmium, et en réalisant un recuit d'inter-diffusion au cours duquel les atomes de cadmium de la couche riche en cadmium vont diffuser dans le substrat, très préférentiellement dans la région dopée P.

Un inconvénient de cette solution est qu'elle nécessite un compromis sur la composition du caisson, pour éviter que ce dernier forme une barrière de potentiel entravant la diffusion des porteurs minoritaires dans la zone de charge d'espace. Il faut donc s'assurer que la concentration en cadmium dans le caisson ne dépasse pas un seuil critique au-delà duquel la sensibilité de la photodiode est fortement affectée. Cela se traduit par la nécessité d'un contrôle précis des conditions du recuit, pour éviter la diffusion d'une trop grande quantité de cadmium vers la région dopée P.

Un objectif de la présente invention est de proposer un dispositif de photo-détection à base de CdₓHg₁₋ₓTe et son procédé de fabrication, qui offre à la fois une sensibilité aux grandes longueurs d'onde et un courant d'obscurité réduit, et qui ne présente pas les inconvénients de l'art antérieur.

### Présentation de l'invention

Cet objectif est atteint avec un procédé de fabrication d'un dispositif de photo-détection, qui comporte les étapes suivantes :
a) dépôt, sur un substrat semiconducteur en CdₓHg₁₋ₓTe, d'un revêtement source qui comporte, au moins, une couche riche en cadmium ayant une plus forte concentration moyenne en cadmium que le substrat semiconducteur, avec la couche riche en cadmium en contact physique direct avec une face supérieure du substrat semiconducteur ;
b) réalisation d'un premier masque de gravure, superposé au revêtement source du côté opposé au substrat semiconducteur ;
c) première étape de gravure, pour graver le revêtement source à travers un premier masque de gravure et former ainsi au moins une première ouverture traversante dans le revêtement source, le revêtement source muni de l'au moins une première ouverture traversante étant nommé revêtement structuré ;
d) deuxième étape de gravure, pour élargir au moins une deuxième ouverture traversante dans une structure surmontant le revêtement structuré à l'issue de la première étape de gravure, et pour former ainsi un deuxième masque de gravure ;
e) injection d'éléments dopants accepteurs dans le substrat semiconducteur, à travers des ouvertures traversantes du deuxième masque de gravure, avec les éléments dopants accepteurs qui traversent localement le revêtement structuré ;
f) activation et diffusion des éléments dopants accepteurs, pour former au moins une région dopée P dans le substrat semiconducteur ;
g) recuit d'inter-diffusion sélective du cadmium, mis en oeuvre après l'étape f) ou au moins en partie simultanément avec l'étape f), au cours duquel des atomes de cadmium diffusent du revêtement structuré vers l'au moins une région dopée P, de manière à former dans chaque région dopée P un caisson concentré avec au moins une zone de gap intermédiaire et au moins une zone fort gap, où la zone de gap intermédiaire présente une concentration moyenne en cadmium strictement inférieure à la concentration moyenne en cadmium dans la zone fort gap ; et
h) dépôt d'une couche de métal venant au contact du substrat semiconducteur au niveau de l'au moins une première ouverture traversante dans le revêtement structuré, pour former au moins un plot de contact électrique.

Une idée à la base de l'invention consiste à réaliser des photodiodes à base de CdₓHg₁₋ₓTe de type P/N, dans lesquelles la région dopée P comporte un caisson concentré riche en cadmium, avec un gradient latéral de la concentration en cadmium dans le caisson concentré. Comme dans l'art antérieur, une concentration moyenne en cadmium dans le caisson concentré est supérieure à une concentration moyenne en cadmium dans la région dopée N (formant une jonction PN respective avec chaque région dopée P). Le gap moyen dans le caisson concentré est donc supérieur au gap moyen dans la région dopée N. En fonctionnement, la zone de charge d'espace s'étend au moins en partie dans le caisson concentré, ce qui permet de réduire le courant d'obscurité. Dans chaque région dopée P, le caisson concentré comporte au moins une zone de gap intermédiaire et au moins une zone fort gap. En fonctionnement, la zone de charge d'espace s'étend en partie dans la zone de gap intermédiaire, et en partie dans la zone fort gap. La zone de gap intermédiaire présente une concentration moyenne en cadmium strictement inférieure à la concentration moyenne en cadmium dans la zone fort gap. Le gap moyen dans la zone de gap intermédiaire est donc inférieur au gap moyen dans la zone fort gap. La collecte des porteurs est assurée par un plot de contact électrique, en contact physique direct avec la région dopée P au niveau de la zone de gap intermédiaire. Pour que la collecte des porteurs reste possible, il suffit donc que le gap moyen dans la zone de gap intermédiaire ne forme pas une barrière de potentiel entravant la diffusion des porteurs minoritaires. Il n'est pas gênant, en revanche, que le gap moyen dans la zone fort gap entrave la diffusion des porteurs minoritaires. Dit autrement, la réduction du courant d'obscurité est assurée, au moins, par la zone fort gap, tandis que la collecte des porteurs est assurée, au moins, par la zone de gap intermédiaire. On s'affranchit ainsi, dans la zone fort gap, des difficultés liées à la recherche d'un compromis entre un gap élevé pour réduire au maximum le courant d'obscurité et un faible gap pour permettre malgré cela la collecte des porteurs. En outre, puisque le gap moyen dans la zone fort gap peut dépasser un seuil limite au-delà duquel il forme une barrière de potentiel pour les porteurs minoritaires, la valeur moyenne du gap dans le caisson concentré peut être augmentée en comparaison avec l'art antérieur. Le courant d'obscurité est donc encore réduit. Enfin, puisque la zone fort gap assure à elle seule une forte réduction du courant d'obscurité, le gap moyen dans la zone de gap intermédiaire peut être suffisamment bas pour assurer une bonne collecte des porteurs de charge quelles que soient les conditions de fonctionnement (température, flux de photons, etc). On s'assure ainsi d'un bon rendement quantique du dispositif de photodétection selon l'invention.

Un tel caisson concentré peut être obtenu en recouvrant un substrat semiconducteur en CdₓHg₁₋ₓTe par une couche structurée riche en cadmium et en réalisant un recuit d'inter-diffusion. Au cours de ce recuit, les atomes de cadmium de la couche structurée vont diffuser jusque dans le substrat, principalement dans la région dopée P. Le gradient de concentration en cadmium est obtenu grâce à une ou plusieurs ouverture(s) traversante(s) percée(s) dans la couche structurée, nommée(s) chacune « première ouverture traversante ». Une zone dans la région dopée P située au regard d'une ouverture traversante dans la couche structurée forme ainsi une zone de gap intermédiaire, tandis qu'une zone dans la région dopée P située au regard d'une région pleine de la couche structurée forme une zone fort gap. On place ensuite le plot de contact électrique, en contact physique direct avec une zone de gap intermédiaire correspondante. Une difficulté qui se pose est de s'assurer d'un espacement suffisant entre la jonction PN et le plot de contact électrique au niveau de la face supérieure du substrat semiconducteur, même pour des régions dopées P de petites dimensions, afin d'éviter l'apparition de courants de fuite par effet tunnel.

Cet espacement suffisant peut être obtenu grâce à un bon alignement entre la zone de gap intermédiaire et le plot de contact électrique. On propose donc, dans la présente invention, un procédé de fabrication astucieux permettant notamment de garantir ce bon alignement entre la zone de gap intermédiaire et le plot de contact électrique. L'idée est de structurer une couche formant réservoir d'atomes de cadmium à l'aide d'un premier masque de gravure (étape c)) puis d'injecter les éléments dopants dans le substrat semiconducteur à travers les ouvertures d'un deuxième masque de gravure (étape e)), avec le deuxième masque de gravure obtenu en élargissant les ouvertures du premier masque de gravure ou d'une autre structure gravée à travers le premier masque de gravure (étape d)). Les ouvertures traversantes destinées à être élargies à l'étape d) sont nommées « deuxièmes ouvertures traversantes ». On obtient ainsi des régions dopées P alignées avec les ouvertures du deuxième masque de gravure, donc alignées avec les ouvertures du premier masque de gravure, et donc alignées avec les ouvertures dans la couche formant réservoir d'atomes de cadmium. La couche formant réservoir d'atomes de cadmium, structurée à travers le premier masque de gravure, est nommée revêtement structurée. Le recuit d'inter-diffusion (étape g)) forme alors, dans les régions dopées P, des zones de gap intermédiaire alignées avec les ouvertures dans le revêtement structuré. Les plots de contact électrique, en contact physique direct avec le substrat semiconducteur au niveau des ouvertures dans le revêtement structuré, sont donc alignés deux à deux avec les zones de gap intermédiaire. L'alignement est obtenu automatiquement, par construction, grâce à l'injection d'éléments dopants à travers les ouvertures d'un deuxième masque de gravure obtenu à partir du premier masque de gravure. Le bon alignement entre une zone de gap intermédiaire et un plot de contact électrique évite l'apparition d'un courant de fuite au niveau de la jonction PN, et offre également une bonne homogénéité de la polarisation de la jonction PN dans le dispositif en utilisation.

Selon un premier mode de réalisation avantageux, le procédé selon l'invention comporte les caractéristiques suivantes :
- à l'étape b), le premier masque de gravure est réalisé directement sur le revêtement source, du côté opposé au substrat semiconducteur ; et
- à l'étape d), la structure surmontant le revêtement structuré à l'issue de la première étape de gravure est constituée par le premier masque de gravure, de sorte que le deuxième masque de gravure est formé dans le matériau du premier masque de gravure.

Une épaisseur du premier masque de gravure est avantageusement adaptée pour que, à l'issue de l'étape d), le deuxième masque de gravure présente une épaisseur supérieure ou égale à un seuil limite en-dessous duquel, à l'étape e), les éléments dopants accepteurs traverseraient le deuxième masque de gravure entre les ouvertures traversantes de ce dernier.

Selon un second mode de réalisation avantageux, le procédé selon l'invention comporte en outre, entre les étapes a) et b), une étape de dépôt d'une couche sacrificielle sur le revêtement source, du côté opposé au substrat semiconducteur, et :
- à l'étape b), le premier masque de gravure est réalisé sur la couche sacrificielle, du côté opposé au substrat semiconducteur ;
- à l'étape c), la couche sacrificielle est gravée conjointement avec le revêtement source, à travers le premier masque de gravure ;
- à l'étape d), la structure surmontant le revêtement structuré à l'issue de la première étape de gravure est constituée par la couche sacrificielle gravée, de sorte que le deuxième masque de gravure est formé dans le matériau de la couche sacrificielle.

Le procédé peut comporter en outre une étape de retrait du premier masque de gravure, mise en oeuvre après l'étape d) et avant l'étape e).

De préférence, à l'étape d), une profondeur de gravure, dans des directions radiales parallèles au plan du substrat semiconducteur, est supérieure ou égale à 1 µm.

Avantageusement, le procédé selon l'invention comporte en outre une étape de comblement de lacunes de mercure, pour former dans le substrat semi-conducteur une région dopée N formant une jonction PN respective avec chaque région dopée P.

A l'issue de l'étape d), le deuxième masque de gravure peut comporter autant d'ouverture(s) traversante(s) que le premier masque de gravure.

En variante, à l'étape d), plusieurs deuxièmes ouvertures traversantes de la structure sont réunies pour ne plus former qu'une seule ouverture traversante, de sorte qu'à l'issue de l'étape d) le deuxième masque de gravure comporte moins d'ouvertures traversantes que le premier masque de gravure.

L'invention couvre également un dispositif de photo-détection à au moins un pixel, obtenu à l'aide d'un procédé selon l'invention, et comportant :
- un substrat semiconducteur en CdₓHg₁₋ₓTe ;
- un revêtement structuré, recouvrant une face supérieure du substrat semiconducteur, et muni d'au moins une première ouverture traversante ; et
- au moins un plot de contact électrique, en métal ;
dans lequel le substrat semiconducteur comporte, pour chaque pixel :
- une région dopée N;
- une région dopée P, formant une jonction PN avec la région dopée N, affleurant la face supérieure du substrat semiconducteur, et en contact physique direct avec l'un respectif parmi l'au moins un plot de contact électrique ; et
- un caisson concentré, localisé uniquement dans la région dopée P et présentant une concentration moyenne en cadmium supérieure à la concentration moyenne en cadmium dans la région dopée N.

Dans chaque pixel :
- la région dopée P comporte une base qui s'étend à partir de la face supérieure du substrat semiconducteur et au moins une protubérance qui fait saillie depuis la base dans la direction opposée à ladite face supérieure du substrat semiconducteur ;
- le caisson concentré présente un gradient de concentration en cadmium, définissant dans ce dernier au moins une zone de gap intermédiaire et au moins une zone fort gap, avec la zone de gap intermédiaire qui présente une concentration moyenne en cadmium strictement inférieure à la concentration moyenne en cadmium dans la zone fort gap ; et
- chaque zone de gap intermédiaire est en contact physique direct avec ledit plot de contact électrique respectif, au niveau d'au moins une première ouverture traversante correspondante du revêtement structuré.

De préférence, chaque pixel comporte une unique zone de gap intermédiaire et une unique zone fort gap, avec la zone de gap intermédiaire agencée concentrique avec la région dopée P et entourée par la zone fort gap.

### Brève description des figures

La présente invention sera mieux comprise à la lecture de la description d'exemples de réalisation donnés à titre purement indicatif et nullement limitatif, en faisant référence aux dessins annexés sur lesquels :
- les figures 1A, 1B, 1C, 1D, 1E, 1F, 1G, 1H, 1I et 1J illustrent de manière schématique les étapes d'un procédé selon un premier mode de réalisation de l'invention ;
- les figures 2A, 2B et 2C illustrent de manière schématique les étapes d'un procédé selon un deuxième mode de réalisation de l'invention ;
- la figure 3 illustre de manière schématique une variante du procédé selon le premier mode de réalisation de l'invention ; et
- les figures 4A et 4B illustrent de manière schématique les étapes d'un procédé selon un troisième mode de réalisation de l'invention.

### Description des modes de réalisation

Dans toute la suite, une concentration moyenne en cadmium désigne une concentration volumique moyenne en atomes de cadmium.

Pour faciliter la lecture, on a représenté sur certaines des figures les axes d'un repère orthonormé (Oxyz).

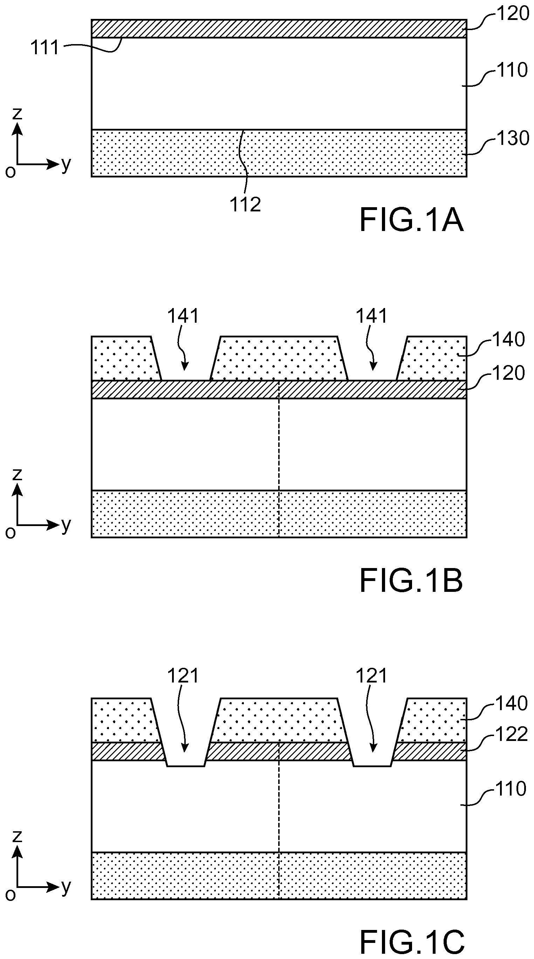

Les figures 1A à 1J illustrent les étapes d'un procédé selon un premier mode de réalisation de l'invention, pour fabriquer un dispositif de photo-détection à au moins un pixel, où chaque pixel du dispositif forme une photodiode.

Dans une première étape, illustrée à la figure 1A, on dépose, sur un substrat semiconducteur 110, un revêtement source 120.

Le substrat semiconducteur 110 est constitué d'un alliage de cadmium, mercure et tellure de type CdₓHg₁₋ₓTe, avec x compris entre 0 et 1, bornes exclues. Il présente ici deux grandes faces parallèles au plan (xOy), qui définissent respectivement une face supérieure 111 et une face inférieure 112 du substrat 110 (substrat fin de type wafer). Le substrat semiconducteur 110 est avantageusement réalisé à l'aide d'une épitaxie ou d'un dépôt chimique en phase vapeur sur un substrat de support 130. Le substrat de support 130 est par exemple un substrat à base de CdZnTe, ou de silicium, ou de germanium, etc.

La concentration moyenne en cadmium dans le substrat semiconducteur 110 est notée x1, et comprise entre x1=0,15 et x1=0,7, plus préférentiellement entre x1=0,18 et x1=0,6, par exemple x1=0,3. Ces concentrations sont adaptées à une absorption de longueurs d'onde allant du proche infrarouge à l'infrarouge lointain.

Le substrat semiconducteur 110 comporte en outre des éléments dopants de type donneur, par exemple de l'indium, à une concentration comprise entre 10¹³ et 10¹⁷ at.cm⁻³, par exemple 10¹⁵ at/cm⁻³.

Ici, la concentration en cadmium est homogène dans tout le volume du substrat semiconducteur 110, de même que la concentration en éléments dopants donneurs. En variante, le substrat semiconducteur 110 peut être constitué de plusieurs couches en CdₓHg₁₋ₓTe, superposées le long de l'axe (Oz), et présentant chacune une valeur distincte de la concentration moyenne en cadmium, par exemple pour réaliser des photodiodes sensibles dans différentes gammes de longueurs d'onde. En complément ou en variante, la concentration en éléments dopants de type donneur peut varier dans le substrat semiconducteur 110, par exemple pour réaliser des photodiodes avec des propriétés améliorées de collecte ou de bruit.

Le revêtement source 120 est déposé directement sur le substrat semiconducteur, par exemple par dépôt physique en phase vapeur, dépôt chimique en phase vapeur, ou jet moléculaire. Le revêtement source 120 comprend, au moins, une couche riche en cadmium dont la concentration moyenne en cadmium est supérieure à celle du substrat semiconducteur 110 dans une région de ce dernier affleurant sa face supérieure 111. De préférence, la concentration moyenne en cadmium dans la couche riche en cadmium est supérieure à la concentration moyenne en cadmium dans tout le substrat semiconducteur 110. Ici, la couche riche en cadmium est en CdTe. En variante, la couche riche en cadmium peut être en CdₓHg₁₋ₓTe, avec une concentration moyenne en cadmium notée x2, et avec un x2-x1≥0,1. La couche riche en cadmium s'étend en contact physique direct avec le substrat semiconducteur 110, ici selon toute l'étendue de la face supérieure 111 de ce dernier. La couche riche en cadmium présente par exemple une épaisseur comprise entre 50 nm et 500 nm, par exemple 200 nm. Ici, le revêtement source 120 est constitué par cette seule couche riche en cadmium. En variante, le revêtement source 120 est constitué d'un empilement de plusieurs couches, parmi lesquelles la couche riche en cadmium.

Dans une deuxième étape, illustrée à la figure 1B, on réalise, sur le revêtement source 120, un premier masque de gravure 140. Ici, le premier masque de gravure 140 s'étend directement sur le revêtement source 120, en contact physique direct avec ce dernier du côté opposé au substrat semiconducteur 110. Le premier masque de gravure 140 comporte des ouvertures traversantes 141, qui s'étendent chacune selon toute l'épaisseur de ce dernier le long de l'axe (Oz). Ici, les ouvertures traversantes 141 ont une section en forme de disque dans des plans parallèles au plan (xOy), avec le diamètre du disque qui augmente légèrement au fur et à mesure que l'on se rapproche du revêtement source 120. Le diamètre des ouvertures traversantes 141 est par exemple de 2 µm, à l'interface entre le premier masque de gravure 140 et le revêtement source 120. D'autres formes d'ouvertures traversantes 141 peuvent être mises en oeuvre sans sortir du cadre de l'invention. Le premier masque de gravure 140 peut être réalisé par dépôt d'une couche de résine photosensible sur le revêtement source 120 puis gravure de la couche de résine, par photolithographie, pour y réaliser les ouvertures traversantes 141.

A chaque étape de sa fabrication, on peut définir des pixels dans le dispositif de photo-détection selon l'invention. On a ici une ouverture traversante 141 du premier masque de gravure par pixel. Sur les figures, les pixels sont délimités par un trait vertical en pointillés.

Dans une troisième étape, illustrée à la figure 1C, le revêtement source 120 est gravé au travers des ouvertures traversantes 141 du premier masque de gravure 140, pour former des ouvertures traversantes 121 dans le revêtement source 120, nommées « premières ouvertures traversantes », qui s'étendent chacune selon toute l'épaisseur de ce dernier le long de l'axe (Oz). Le revêtement source muni des ouvertures traversantes 121 est nommé revêtement structuré 122. Cette étape forme une première étape de gravure, pouvant mettre en oeuvre une gravure par voie sèche ou humide, réactive ou non, ou une combinaison de ces techniques. De préférence, la première étape de gravure met en oeuvre une gravure sèche par abrasion ionique. La première étape de gravure conserve sensiblement inchangés les diamètres des ouvertures traversantes 141 du premier masque de gravure 140. Ici, la première étape de gravure grave également le substrat semiconducteur 110, de manière superficielle (sur une épaisseur inférieure à 1000 nm, par exemple 200 nm). La première étape de gravure entraîne également une légère réduction de l'épaisseur du premier masque de gravure 140.

La première étape de gravure permet de réaliser un revêtement structuré 122 formant réservoir de cadmium, muni d'ouvertures traversantes 121 alignées chacune avec une ouverture traversante respective 141 du premier masque de gravure 140. Des ouvertures traversantes 121 et 141, alignées deux à deux et appartenant respectivement au revêtement structuré 120 et au premier masque de gravure 140, ont sensiblement la même forme et les mêmes dimensions dans des plans parallèles au plan (xOy).

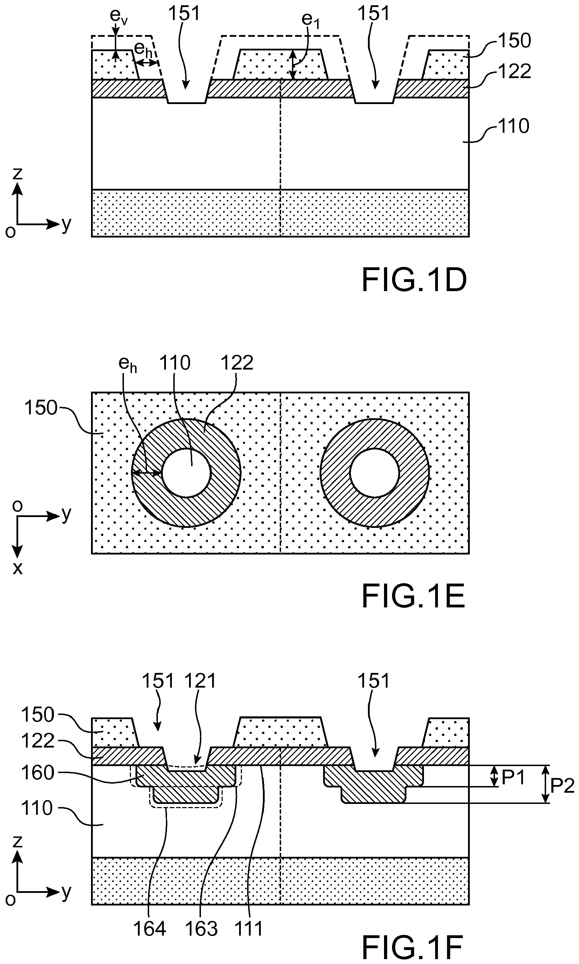

Dans une quatrième étape, illustrée aux figures 1D et 1E, le premier masque de gravure 140 est gravé pour élargir les ouvertures traversantes 141 de ce dernier, et former ainsi un deuxième masque de gravure 150 à partir du premier masque de gravure 140. Les ouvertures traversantes 141 du premier masque de gravure sont alors nommées « deuxièmes ouvertures traversantes ». Sur la figure 1D, on a représenté une vue en coupe de l'ensemble obtenu à l'issue de cette deuxième étape de gravure, avec en pointillés la forme du premier masque de gravure 140 juste avant cette deuxième étape de gravure. Sur la figure 1E, on a représenté une vue de dessus de cet ensemble.

La deuxième étape de gravure réalise ainsi un deuxième masque de gravure 150, avec les ouvertures traversantes 151 du deuxième masque de gravure 150 alignées deux à deux avec les ouvertures traversantes 141 du premier masque de gravure 140, et avec les ouvertures traversantes 151 du deuxième masque de gravure 150 plus larges que les ouvertures traversantes 141 du premier masque de gravure 140. Par conséquent, les ouvertures traversantes 121 du revêtement structuré 122 sont alignées deux à deux avec les ouvertures traversantes 151 du deuxième masque de gravure 150, et les ouvertures traversantes 151 du deuxième masque de gravure 150 sont plus larges que les ouvertures traversantes 121 du revêtement structuré 122. Au regard de chaque ouverture traversante 151 du deuxième masque de gravure 150, se trouve donc une zone où affleure le substrat semiconducteur 110 entourée d'une zone où affleure le matériau du revêtement structuré 122 (voir figure 1E).

La deuxième étape de gravure met en oeuvre une gravure sélective, qui ne grave pas le matériau du revêtement structuré 122. Cette deuxième étape de gravure peut mettre en oeuvre une gravure sèche réactive, par exemple une gravure par plasma à base de dioxygène avec addition d'Ar, CF₄, HBr, Cl₂ ou une combinaison de ces additifs. La deuxième étape de gravure peut être une gravure isotrope, dans laquelle l'étendue verticale de la gravure (profondeur de gravure selon l'axe (Oz)) est égale à l'étendue latérale de la gravure (profondeur de gravure dans des directions radiales, situées dans le plan (xOy), orthogonales à la tangente au bord de l'ouverture traversante 141 du premier masque de gravure). En variante, le procédé selon l'invention peut être adapté pour qu'à la deuxième étape de gravure, l'étendue latérale de la gravure soit strictement supérieure à l'étendue verticale de la gravure, d'un facteur compris par exemple entre 1.2 et 2. Il est ainsi possible de limiter la réduction d'épaisseur du premier masque de gravure 140 apportée par la deuxième étape de gravure, pour une même largeur des ouvertures traversantes 151 du deuxième masque de gravure 150. Cette propriété de la gravure peut être obtenue par un durcissement de la face supérieure du premier masque de gravure 140, par exemple à l'aide d'une deuxième étape de gravure mettant en oeuvre un flux ionique bombardant la face supérieure du premier masque de gravure dans un procédé de gravure plasma. En variante, cette propriété peut être obtenue par le dépôt de précurseur sur la face supérieure du premier masque de gravure 140, ralentissant une gravure chimique verticale.

Sur la figure 1D, on a représenté l'étendue verticale eᵥ de la gravure, le long de l'axe (Oz), et l'étendue radiale en de la gravure, dans des directions radiales situées dans des plans (xOy). On a également représenté l'épaisseur e₁ du deuxième masque de gravure 150, correspondant à l'épaisseur du premier masque de gravure diminuée de l'étendue verticale eᵥ de la gravure.

Dans une cinquième étape, illustrée à la figure 1F, des éléments dopants accepteurs sont injectées dans le substrat semiconducteur 110, à travers les ouvertures traversantes 151 du deuxième masque de gravure 150. Les éléments dopants accepteurs sont par exemple des atomes d'arsenic, injectés par implantation ionique avec une énergie de 400 keV, et une dose de 5.10¹⁴ at.cm⁻³. Après une étape d'activation et diffusion des éléments dopants injectés, ces derniers forment des régions dopées P 160 dans le substrat semiconducteur.

Les éléments dopants injectés au regard des zones pleines du deuxième masque de gravure 150 ne parviennent pas jusque dans le substrat semiconducteur 110. Pour cela, l'épaisseur e₁ du deuxième masque de gravure 150 doit rester supérieure ou égale à une valeur seuil prédéterminée. On comprend ici l'intérêt de limiter une réduction d'épaisseur du premier masque de gravure 140, lors des étapes précédentes. En particulier, l'épaisseur e₁ doit rester supérieure ou égale à une valeur seuil, en dessous de laquelle les éléments dopants injectés au regard des zones pleines du deuxième masque de gravure 150 traverseraient ce deuxième masque de gravure 150 sur toute son épaisseur. Cette valeur seuil vaut par exemple 0,8 µm, dans les conditions d'implantation mentionnées ci-avant.

En outre, les éléments dopants injectés au regard des ouvertures traversantes 151 du deuxième masque de gravure, dans une zone où affleure le matériau du revêtement structuré 122, s'enfoncent jusqu'à une première profondeur P1 dans le substrat semiconducteur 110.

Enfin, les éléments dopants injectés au regard des ouvertures traversantes 151 du deuxième masque de gravure, dans une zone où affleure le substrat semiconducteur 110, s'enfoncent jusqu'à une deuxième profondeur P2 dans le substrat semiconducteur 110, avec P2 strictement supérieur à P1. Pour cela, l'épaisseur du revêtement structuré 122 (et donc du revêtement source 120) doit rester inférieure ou égale à une valeur seuil prédéterminée. Ladite valeur seuil prédéterminée est fonction de la nature des éléments dopants injectés et de l'énergie d'implantation. Ici, le revêtement structuré 122 présente une épaisseur de 200 nm, permettant que des atomes d'arsenic implantés avec une énergie de 400 keV parviennent jusqu'au substrat semiconducteur 110.

On obtient ainsi des régions dopées P avec chacune une base 163, s'étendant à partir de la face supérieure 111 du substrat semiconducteur 110, et une protubérance 164, faisant saillie à partir de la base dans la direction opposée à la face supérieure 111 du substrat semiconducteur. La largeur de la base 163 est définie par la largeur de l'ouverture traversante 151 correspondante dans le deuxième masque de gravure 150. La largeur de la protubérance 164 est définie par la largeur de l'ouverture traversante 121 correspondante dans le revêtement structuré 122. Chaque région dopée P 160 est centrée ici sur une ouverture traversante respective 151 du deuxième masque de gravure 150, et sur une ouverture traversante respective 121 du revêtement structuré 122. Dans chaque région dopée P, une zone centrale est surmontée par l'ouverture traversante respective 121 du revêtement structuré 122, et une zone périphérique est surmontée par le matériau dudit revêtement structuré 122. Chaque région dopée P est associée à un pixel respectif du dispositif de photo-détection en cours de fabrication.

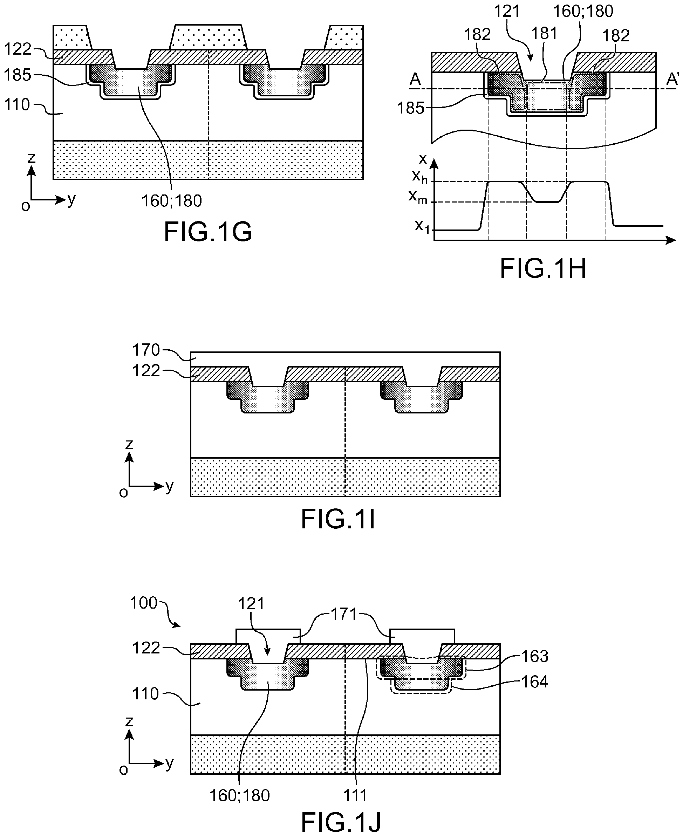

Dans une sixième étape, illustrée aux figures 1G et 1H, on réalise un recuit d'inter-diffusion sélective du cadmium, au cours duquel les atomes de cadmium du revêtement structuré 122 diffusent vers le substrat semiconducteur 110. Ce recuit comprend de préférence une phase de recuit à haute température, à une température comprise entre 100 °C et 500 °C, plus préférentiellement entre 300°C et 500°C et même entre 350°C et 450°C, et pendant une durée supérieure à une minute, comprise de préférence entre 10 minutes et 50 heures, voire entre 30 minutes et 50 heures, et même entre 30 minutes et 30 heures, par exemple une heure.

Durant ce recuit, le cadmium diffuse préférentiellement dans les régions dopées P 160. On parle donc d'une inter-diffusion sélective. On obtient ainsi une répartition du cadmium dans le substrat semiconducteur 110, avec dans chaque pixel une forte concentration moyenne en cadmium dans la région dopée P 160. Dans chaque pixel, la concentration en cadmium décroît rapidement, dans une zone intermédiaire 185 qui s'étend au niveau de l'interface entre la région dopée P 160 et le restant du substrat semiconducteur (cette interface correspondant à la future jonction PN). Ladite zone intermédiaire 185 peut s'étendre d'un côté et/ou de l'autre de la future jonction PN. De préférence, ladite zone intermédiaire 185 s'étend des deux côtés de la future jonction PN. On peut ainsi définir, dans chaque région dopée P, un caisson concentré 180 respectif qui présente une concentration moyenne en cadmium supérieure à la concentration moyenne en cadmium dans le restant du substrat semiconducteur 110. Chaque caisson concentré 180 s'étend uniquement à l'intérieur de la région dopée P correspondante, et n'inclut donc pas forcément la zone intermédiaire 185. Chaque caisson concentré 180 et la région dopée P 160 correspondante sont agencées concentriques. On considère dans la suite que chaque caisson concentré 180 est exactement superposé avec la région dopée P 160 correspondante.

Le cadmium diffuse dans les régions dopées P 160, depuis des surfaces de recouvrement entre les régions dopées P 160 et le revêtement structuré 122. Ainsi, dans chaque région dopée P 160, le caisson concentré 180 présente un gradient latéral de cadmium. Dans le caisson concentré 180, la concentration en cadmium est maximale au regard de la surface de recouvrement entre la région dopée P 160 et le revêtement structuré 122, puis décroît au fur et à mesure que l'on s'éloigne de cette surface de recouvrement. On peut ainsi définir, dans le caisson concentré 180, une zone de gap intermédiaire entourée par une zone fort gap.

A la figure 1H, on a représenté une vue de détail de l'ensemble obtenu à l'issue du recuit d'inter-diffusion, et un profil correspondant de concentration x en cadmium le long d'un axe AA' parallèle au plan (xOy) et passant par la région dopée P. La concentration en cadmium prend :
- une valeur basse x₁ à l'extérieur de la région dopée P et de la zone intermédiaire 185, et
- une valeur haute xₕ, dans la région dopée P et au regard des surfaces de recouvrement entre la région dopée P et le revêtement structuré 122.

Une zone de transition brutale de la valeur basse x₁ à la valeur haute xₕ correspond à la zone intermédiaire 185 telle que mentionnée ci-dessus. La valeur haute xₕ est strictement supérieure à la valeur basse x₁, avec de préférence xₕ≥ (x₁+0,1). En outre, la valeur haute xₕ est avantageusement entre 1,5 et 5 fois plus élevée que x₁. Il n'existe pas de limitation forte venant limiter la valeur maximale prise par xₕ, cette valeur pouvant atteindre xₕ=0,95.

Au regard des ouvertures 121 du revêtement structuré 122, la concentration en cadmium varie progressivement de la valeur haute xₕ jusqu'à une valeur intermédiaire xₘ. La valeur intermédiaire xₘ est strictement inférieure à xₕ. De préférence, la valeur intermédiaire xₘ vérifie en outre x_{ab}≤xₘ≤ (x_{ab}+0,1), avec x_{ab} la concentration en cadmium dans une région du substrat semiconducteur 110 dédiée à l'absorption de photons incidents. Pour simplifier, on peut considérer que x₁=x_{ab}. On peut définir la zone de gap intermédiaire comme étant le volume 181, dans le caisson concentré 180, situé au regard de l'ouverture traversante 121 dans le revêtement structuré 122. De même, on peut définir la zone fort gap comme étant le volume 182, dans le caisson concentré, situé au regard de zones pleines du revêtement structuré 122.

En fonctionnement, dans le dispositif de photo-détection obtenu *in fine*, chaque zone dopée P définit une jonction PN avec le restant du substrat semiconducteur 110, et une zone de charge d'espace s'étend de part et d'autre de cette jonction PN, pour partie dans le caisson concentré 180. Une région dopée N du substrat semiconducteur forme une région d'absorption, dédiée à l'absorption de photons incidents. La longueur d'onde des photons absorbés est fonction du gap dans ladite région dopée N. Grâce à la plus forte concentration moyenne en cadmium dans le caisson concentré 180, le dispositif de photo-détection peut détecter des photons à de grandes longueurs d'onde tout en présentant un courant d'obscurité réduit. Dans chaque région dopée P, la collecte des porteurs de charge est réalisée au niveau de la zone de gap intermédiaire 181. Par conséquent, la présence éventuelle d'une barrière de potentiel au niveau de la zone fort gap 182 n'empêche pas une collecte efficace des porteurs de charge. On peut donc augmenter une valeur moyenne du gap dans la zone de charge d'espace, en comparaison avec l'art antérieur, et ainsi réduire encore le courant d'obscurité pour une même gamme de sensibilité spectrale.

A l'issue de ce recuit, ou en variante préalablement au recuit, le deuxième masque de gravure 150 est retiré. Ensuite, dans une septième étape illustrée en figure 1I, l'ensemble obtenu est recouvert d'une couche de métal 170, déposée par exemple par évaporation. La couche de métal 170 peut être constituée d'une unique couche ou d'un empilement multicouches, et peut comprendre un ou plusieurs éléments tels que de l'or, du titane, du nickel, un alliage de métaux, etc. La couche de métal 170 recouvre le revêtement structuré 122 et pénètre à l'intérieur des ouvertures traversantes 121 dans ce dernier. Elle est donc en contact physique direct avec les régions dopées P, uniquement au niveau des ouvertures traversantes 121 dans le revêtement structuré, au regard des zones de gap intermédiaire.

Dans une huitième étape, illustrée en figure 1J, la couche de métal 170 est gravée localement, par exemple par photolithographie et gravure, pour délimiter des plots de contact électrique 171.

En variante des septième et huitième étapes, la couche de métal est déposée sur un masque réalisé sur le revêtement structuré, puis le masque est retiré de sorte qu'il ne reste que les plots de contact électrique (technique dite de lift-off).

Dans tous les cas, on réalise ainsi des plots de contact électrique, avec une surface de contact étroite entre le plot de contact électrique et la région dopée P, automatiquement alignée sur la zone de gap intermédiaire. On assure ainsi, en fonctionnement, une collecte efficace des porteurs de charge. On s'assure ainsi, en outre, d'un éloignement suffisant entre le plot de contact électrique et la jonction PN, empêchant l'apparition de courants de fuite par effet tunnel.

L'éloignement entre le plot de contact électrique et la jonction PN est défini par l'étendue radiale en de la gravure (ou profondeur de gravure dans des directions radiales parallèles au plan (xOy) du substrat semiconducteur 110), à la deuxième étape de gravure (voir figures 1D et 1E). Cette étendue radiale en est de préférence supérieure ou égale à 1 µm, voire supérieure ou égale à 1,5 µm, par exemple égale à 2 µm. Dit autrement, à la deuxième étape de gravure, l'au moins une ouverture traversante est élargie de sorte que son diamètre soit augmenté d'au moins 2 µm, voire au moins 3 µm, par exemple augmenté de 4 µm (où le diamètre de l'ouverture traversante est la plus grande largeur d'une section de ladite ouverture traversante dans un plan (xOy) parallèle au plan du substrat semiconducteur).

Cette étendue radiale en définit également les dimensions d'une surface d'échange entre les zones pleines du revêtement structuré 122 et une région dopée P, et participe donc à définir un profil du gradient de gap dans le caisson concentré et seuil maximal du gap dans le caisson concentré.

Le procédé selon l'invention comporte également une étape, non représentée, de recuit à basse température sous pression saturante de vapeur de mercure, pour combler des lacunes de mercure formées dans le substrat semiconducteur 110 et former des jonctions PN respectives entre les régions dopées P 160 et le restant du substrat semiconducteur 110. Ce recuit peut être mis en oeuvre après le recuit d'inter-diffusion sélective du cadmium. En variante, ce recuit peut former une phase finale basse température du recuit d'inter-diffusion sélective du cadmium. Le recuit à basse température est réalisé à une température comprise par exemple entre 150°C et 200°C.

De même, l'étape d'activation et diffusion des éléments dopants accepteurs injectés, mentionnée ci-avant, peut être mise en oeuvre avant ou au moins en partie pendant le recuit d'inter-diffusion sélective du cadmium.

Des étapes ultérieures d'hybridation sur un circuit de lecture, retrait optionnel du substrat de support, dépôt de fonctions optiques sur la face avant telles que des couches anti-reflet et/ou filtres, etc, ne sont pas décrites mais pourront être mises en oeuvre sans sortir du cadre de l'invention.

Dans un exemple de réalisation avantageux, le premier masque de gravure 140 présente une épaisseur de 3 µm et des ouvertures traversantes circulaires de 2 µm de diamètre réparties de façon régulière dans le plan (xOy) avec un pas de répartition égal à 10 µm. A la première étape de gravure, le revêtement source est gravé par abrasion ionique pour former le revêtement structuré. Cette première étape de gravure réduit également l'épaisseur du premier masque de gravure 140. Par exemple, la première étape de gravure grave des ouvertures traversantes dans un revêtement source de 0,2 µm d'épaisseur, et conduit à une réduction d'épaisseur de 0,2 µm du premier masque de gravure 140. Le premier masque de gravure est ensuite gravé par plasma de dioxygène, avec une étendue de la gravure de 2 µm dans toutes les directions. On obtient ainsi un deuxième masque de gravure 150, d'épaisseur 0,8 µm, avec des ouvertures traversantes circulaires de 6 µm de diamètre réparties avec un pas de répartition égal à 10 µm. L'épaisseur du deuxième masque de gravure 150 est suffisante pour stopper l'implantation d'arsenic, injecté par implantation ionique avec une énergie de 400 keV et une dose de 5.10¹⁴ at.cm⁻³. Dans le dispositif de photodétection *in fine,* un éloignement entre les bords du plot de contact électrique 171 et les bords de la jonction PN, dans le plan de la face supérieure 111 du substrat semiconducteur, est ainsi supérieur ou égal à 2 µm.

La figure 1J montre le dispositif de photo-détection 100 obtenu à l'aide du procédé décrit ci-dessus. Le dispositif de photo-détection 100 comporte le substrat semiconducteur 110 en CdₓHg₁₋ₓTe, surmonté par le revêtement structuré 122. Le revêtement structuré comporte, au moins, une couche riche en cadmium en contact physique direct avec le substrat semiconducteur 110. Même après le recuit d'inter-diffusion, la concentration moyenne en cadmium dans la couche riche en cadmium est supérieure à la concentration moyenne en cadmium dans le substrat semiconducteur 110 (le cadmium ne diffusant que dans une partie seulement du substrat semiconducteur). Dans chaque pixel du dispositif 100, une région dopée P respective 160 s'étend dans le substrat semiconducteur 110, et définit une jonction PN avec le restant du substrat semiconducteur 110. Chaque région dopée P comporte une base 163 et une protubérance telles que décrites ci-avant. Chaque protubérance 164 est alignée avec ouverture traversante 121 respective du revêtement structuré 122, et présente sensiblement la même section que ladite ouverture traversante 121 dans des plans parallèles au plan (xOy). Le volume de la protubérance 164 est strictement inférieur à celui de la base 163. Chaque région dopée P 160 reçoit un caisson concentré respectif 180, tel que décrit ci-avant, avec une zone fort gap et une zone de gap intermédiaire. Ici, la zone de gap intermédiaire est agencée concentrique avec la région dopée P 160, et entourée par la zone fort gap. La zone de gap intermédiaire est en contact physique direct avec un plot de contact électrique 171 respectif, au niveau d'une ouverture traversante respective 121 du revêtement structuré. Au niveau de la face supérieure 111 du substrat semiconducteur 110, les bords du plot de contact électrique 171 sont espacés de la jonction PN définie par la région dopée P 160.

Dans chaque pixel, une distance entre les bords de la jonction PN et les bords de l'ouverture traversante 121 dans le revêtement structuré, dans le plan de la face supérieure 111 du substrat semiconducteur 110 et dans des directions radiales, est avantageusement supérieure ou égale à une valeur seuil *D*. La direction radiale est ici une direction orthogonale à la tangente au bord de l'ouverture traversante 121, dans le plan de la face supérieure 111 du substrat semiconducteur 110. De la même manière, une distance entre les bords de la jonction PN et les bords du plot de contact électrique 171 est avantageusement supérieure ou égale à la valeur seuil *D*, dans le plan de la face supérieure 111 du substrat semiconducteur 110 et dans des directions radiales. La valeur seuil vaut de préférence 1,0 µm, ou 1,5 µm, ou même 2,0 µm. De manière similaire, une distance entre les bords de la base 163 et les bords de la protubérance 164, dans une projection orthogonale de la région dopée P 160 dans un plan parallèle au plan (xOy), est avantageusement supérieure ou égale à la valeur seuil *D*.

Le procédé selon l'invention permet ainsi de fabriquer un dispositif de photodétection à bas niveau de bruit. Le procédé met en oeuvre un nombre réduit d'étapes de fabrication, ce qui améliore la robustesse du dispositif fabriqué et augmente une productivité de la fabrication.

Le revêtement structuré 122 forme une couche de passivation, protégeant le substrat semiconducteur 120. Dans le procédé selon l'invention, les régions dopées P 160 sont réalisées après la gravure des ouvertures traversantes 121 du revêtement structuré. On limite ainsi des contraintes d'états d'interface, ce qui permet de recourir à des procédés de gravure très précis pour la gravure des ouvertures traversantes 121, par exemple des procédés de gravure sèche anisotrope. On peut ainsi réduire une surface de contact entre le plot de contact électrique et la région dopée P correspondante, et réduire un pas de pixel du dispositif selon l'invention.

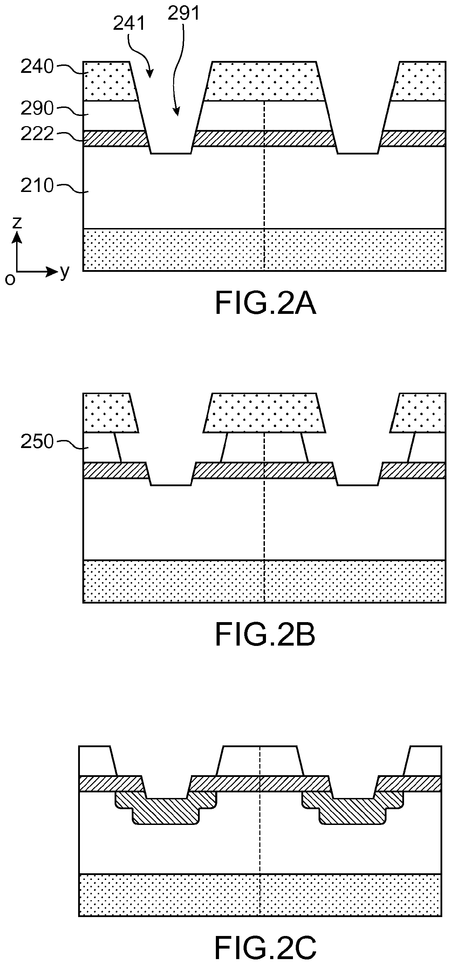

Les figures 2A à 2C illustrent les étapes d'un procédé selon un deuxième mode de réalisation de l'invention, qui ne sera décrit que pour ses différences relativement au procédé selon le premier mode de réalisation de l'invention. Dans ce deuxième mode de réalisation, le procédé comporte les étapes suivantes :
- dépôt, sur le revêtement source et du côté opposé au substrat semiconducteur 210, d'une couche sacrificielle 290. Ici, la couche sacrificielle 290 est en contact physique direct avec le revêtement source selon toute son étendue dans un plan (xOy).
- réalisation du premier masque de gravure 240, tel que décrit ci-avant, ici sur la couche sacrificielle 290, du côté opposé au substrat semiconducteur 210. Ici, le masque de gravure 240 est en contact physique direct avec la couche sacrificielle 290.
- gravure conjointe de la couche sacrificielle 290 et du revêtement source, à travers les ouvertures traversantes 241 du premier masque de gravure 240 (voir figure 2A). Cette première étape de gravure forme des ouvertures traversantes 291 dans la couche sacrificielle 290, avec les ouvertures traversantes 241 du premier masque de gravure 240 et les ouvertures traversantes 291 de la couche sacrificielle 290 alignées deux à deux et sensiblement de même largeur. Cette première étape de gravure forme en outre le revêtement structuré 222 tel que décrit ci-avant, avec les ouvertures traversantes du revêtement structuré 222 et les ouvertures traversantes 291 de la couche sacrificielle 290 alignées deux à deux et sensiblement de même largeur.

- deuxième étape de gravure, pour élargir les ouvertures traversantes 291 de la couche sacrificielle 290 (voir figure 2B). Les ouvertures traversantes 291 de la couche sacrificielle 290 sont alors nommées « deuxièmes ouvertures traversantes ». La couche sacrificielle dont les ouvertures traversantes sont élargies forme un deuxième masque de gravure 250 tel que décrit ci-avant. La couche sacrificielle est par exemple en SiOz, gravée par une gravure humide dans une solution acide à base d'acide fluorhydrique.
- après retrait du premier masque de gravure 240, injections d'éléments dopants accepteurs à travers les ouvertures traversantes du deuxième masque de gravure, comme décrit-avant (figure 2C).

Les étapes sont suivies des étapes décrites ci-avant de recuit d'inter-diffusion sélective du cadmium, retrait du deuxième masque de gravure et réalisation de plots de contact électrique.

Les dimensions du deuxième masque de gravure doivent répondre aux mêmes exigences que dans le premier mode de réalisation. En particulier, l'épaisseur de la couche sacrificielle 290 doit être suffisante pour empêcher les éléments dopants accepteurs injectés d'atteindre le substrat semiconducteur 210. Pour une implantation ionique d'arsenic à 400 keV, on utilise par exemple une couche sacrificielle en SiO₂, d'épaisseur supérieure ou égale à 500 nm.

A la deuxième étape de gravure, la couche sacrificielle 290 destinée à former le deuxième masque de gravure n'est gravée que dans les directions radiales. L'étendue de la gravure dans les directions radiales peut être aisément ajustée, notamment par une durée de mise en contact avec une solution acide et/ou une concentration en acide. Dans la direction verticale, la couche sacrificielle est protégée par le premier masque de gravure, de sorte que son épaisseur reste inchangée. Le deuxième mode de réalisation facilite donc l'ajustement des dimensions des ouvertures traversantes du deuxième masque de gravure.

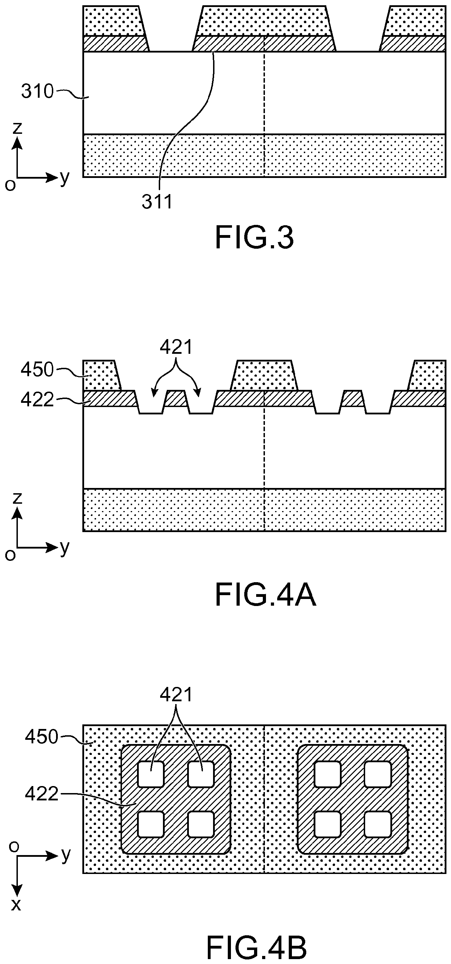

La figure 3 illustre une variante du procédé selon le premier mode de réalisation de l'invention, dans laquelle la gravure du revêtement source (première étape de gravure) ne grave pas du tout le matériau du substrat semiconducteur 310. La face supérieure 311 du substrat semiconducteur reste entièrement plane. Une telle gravure, totalement sélective, peut également être mise en oeuvre dans une variante du procédé selon le deuxième mode de réalisation de l'invention.

Les figures 4A et 4B illustrent de manière schématique les étapes d'un procédé selon un troisième mode de réalisation de l'invention. Ce mode de réalisation ne sera décrit que pour ses différences relativement au premier mode de réalisation. Dans ce mode de réalisation, le premier masque de gravure comporte, pour chaque pixel du dispositif de photo-détection, une pluralité d'ouvertures traversantes. Le revêtement source est gravé, pour former un revêtement structuré 422 avec autant d'ouvertures traversantes que le premier masque de gravure. Le revêtement structuré 422 comporte donc, dans chaque pixel, une pluralité d'ouvertures traversantes 421.

A la deuxième étape de gravure, dans chaque pixel, les plusieurs ouvertures traversantes d'une structure surmontant le revêtement structuré sont réunies en une seule ouverture traversante. Ici, ladite structure est formée par le premier masque de gravure. En variante, elle peut être formée par une couche sacrificielle, comme dans le mode de réalisation des figures 2A à 2C. La deuxième étape de gravure forme ainsi un deuxième masque de gravure 450, avec une ouverture traversante par pixel du dispositif de photodétection. Dans le dispositif de photodétection obtenu *in fine,* la région dopée P comporte donc plusieurs protubérances, chacune au regard d'une ouverture traversante respective du revêtement structuré. En outre, le caisson concentré de chaque région dopée P comporte plusieurs zones de dopage intermédiaire, chacune au regard d'une ouverture traversante respective du revêtement structuré. Enfin, dans chaque pixel, le plot de contact électrique comporte plusieurs excroissances, chacune venant au contact d'une zone de dopage intermédiaire respective au travers d'une ouverture traversante respective du revêtement structuré. Ce mode de réalisation permet d'assurer une collecte optimale des porteurs de charge, et d'offrir une bonne fonction de transfert de modulation.

L'invention n'est pas limitée à de l'arsenic comme élément dopant accepteur, ni aux énergies d'implantation et doses mentionnées dans les exemples. D'autres éléments dopants accepteurs tels que Li, Na, K, Rb, Cs, Ag, Au, Cu, N, P, Sb, etc peuvent notamment être utilisés, avec des énergies d'implantation comprises avantageusement entre 50 keV et 1000 keV pour des revêtements structurés d'épaisseur comprise entre 50 nm et 1000 nm. De même, l'invention n'est pas limitée aux dimensions et matériaux cités en exemple. Elle n'est pas non plus limitée à une forme ni à un nombre d'ouverture(s) traversante(s) par pixel dans le revêtement structuré. On pourrait par exemple avoir une ouverture traversante annulaire par pixel dans le revêtement structuré, avec en conséquence une région dopée P avec une protubérance annulaire et un caisson concentré avec une zone de gap intermédiaire annulaire.

L'invention propose ainsi un procédé pour réaliser au moins une photodiode P/N faible bruit. Dans chaque pixel, une surface de contact entre le contact électrique en métal et la région dopée P est automatiquement alignée, par construction, avec une zone de gap intermédiaire dans la région dopée P dédiée à la collecte des porteurs de charge. De préférence, le contact électrique est, par construction, parfaitement centré sur la région dopée P. L'invention est particulièrement adaptée à la fabrication de dispositifs de photo-détection de type matriciel, avec un pas de répartition des pixels inférieur ou égal à 10 µm.

## Revendications

1. Procédé de fabrication d'un dispositif de photo-détection (100), qui comporte les étapes suivantes :
a) dépôt, sur un substrat semiconducteur (110 ; 210 ; 310) en CdₓHg₁₋ₓTe, d'un revêtement source (120) qui comporte, au moins, une couche riche en cadmium ayant une plus forte concentration moyenne en cadmium que le substrat semiconducteur, avec la couche riche en cadmium en contact physique direct avec une face supérieure (111 ;311) du substrat semiconducteur ;
b) réalisation d'un premier masque de gravure (140 ; 240), superposé au revêtement source du côté opposé au substrat semiconducteur ;
c) première étape de gravure, pour graver le revêtement source (120) à travers le premier masque de gravure (140 ; 240) et former ainsi au moins une première ouverture traversante (121) dans le revêtement source, le revêtement source muni de l'au moins une première ouverture traversante étant nommé revêtement structuré (122 ; 222 ; 422) ;
d) deuxième étape de gravure, pour élargir au moins une deuxième ouverture traversante (141; 291) dans une structure (140 ; 290) surmontant le revêtement structuré (122 ; 222) à l'issue de la première étape de gravure, et pour former ainsi un deuxième masque de gravure (150 ; 250 ; 450) ;
e) injection d'éléments dopants accepteurs dans le substrat semiconducteur (110 ; 210 ; 310), à travers des ouvertures traversantes (151) du deuxième masque de gravure (150 ; 250 ; 450), avec les éléments dopants accepteurs qui traversent localement le revêtement structuré (122 ; 222) ;
f) activation et diffusion des éléments dopants accepteurs, pour former au moins une région dopée P (160) dans le substrat semiconducteur ;
g) recuit d'inter-diffusion sélective du cadmium, mis en oeuvre après l'étape f) ou au moins en partie simultanément avec l'étape f), au cours duquel des atomes de cadmium diffusent du revêtement structuré (122 ; 222) vers l'au moins une région dopée P (160), de manière à former dans chaque région dopée P un caisson concentré (180) avec au moins une zone de gap intermédiaire (181) et au moins une zone fort gap (182), où la zone de gap intermédiaire (181) présente une concentration moyenne en cadmium strictement inférieure à la concentration moyenne en cadmium dans la zone fort gap (182) ; et
h) dépôt d'une couche de métal (170) venant au contact du substrat semiconducteur (110 ; 210 ; 310) au niveau de l'au moins une première ouverture traversante (121) dans le revêtement structuré (122 ; 222), pour former au moins un plot de contact électrique (171).

2. Procédé selon la revendication 1, **caractérisé en ce que** :
- à l'étape b), le premier masque de gravure (140) est réalisé directement sur le revêtement source (120), du côté opposé au substrat semiconducteur (110) ; et
- à l'étape d), la structure surmontant le revêtement structuré (122) à l'issue de la première étape de gravure est constituée par le premier masque de gravure (140), de sorte que le deuxième masque de gravure (150) est formé dans le matériau du premier masque de gravure.

3. Procédé selon la revendication 2, **caractérisé en ce qu'**une épaisseur du premier masque de gravure (140) est adaptée pour que, à l'issue de l'étape d), le deuxième masque de gravure (150) présente une épaisseur (e₁) supérieure ou égale à un seuil limite en-dessous duquel, à l'étape e), les éléments dopants accepteurs traverseraient le deuxième masque de gravure (150) entre les ouvertures traversantes de ce dernier.

4. Procédé selon la revendication 1, **caractérisé en ce qu'**il comporte en outre, entre les étapes a) et b), une étape de dépôt d'une couche sacrificielle (290) sur le revêtement source, du côté opposé au substrat semiconducteur (210), et **en ce que** :
- à l'étape b), le premier masque de gravure (240) est réalisé sur la couche sacrificielle (290), du côté opposé au substrat semiconducteur (210) ;
- à l'étape c), la couche sacrificielle (290) est gravée conjointement avec le revêtement source, à travers le premier masque de gravure (240) ;
- à l'étape d), la structure surmontant le revêtement structuré (222) à l'issue de la première étape de gravure est constituée par la couche sacrificielle gravée, de sorte que le deuxième masque de gravure (250) est formé dans le matériau de la couche sacrificielle.

5. Procédé selon la revendication 4, **caractérisé en ce qu'**il comporte en outre une étape de retrait du premier masque de gravure (140 ; 240), mise en oeuvre après l'étape d) et avant l'étape e).

6. Procédé selon l'une quelconque des revendications 1 à 5, **caractérisé en ce qu'**à l'étape d), une profondeur de gravure, dans des directions radiales parallèles au plan du substrat semiconducteur, est supérieure ou égale à 1 µm.

7. Procédé selon l'une quelconque des revendications 1 à 6, **caractérisé en ce qu'**il comporte en outre une étape de comblement de lacunes de mercure, pour former dans le substrat semi-conducteur (110 ; 210 ; 310) une région dopée N formant une jonction PN respective avec chaque région dopée P (160).

8. Procédé selon l'une quelconque des revendications 1 à 7, **caractérisé en ce qu'**à l'issue de l'étape d), le deuxième masque de gravure (150 ; 250) comporte autant d'ouverture(s) traversante(s) que le premier masque de gravure (140 ; 240).

9. Procédé selon l'une quelconque des revendications 1 à 7, **caractérisé en ce qu'**à l'étape d), plusieurs deuxièmes ouvertures traversantes de la structure sont réunies pour ne plus former qu'une seule ouverture traversante, de sorte qu'à l'issue de l'étape d) le deuxième masque de gravure (450) comporte moins d'ouvertures traversantes que le premier masque de gravure.

10. Dispositif de photo-détection (100) à au moins un pixel, obtenu à l'aide d'un procédé selon l'une quelconque des revendications 1 à 9, et comportant :
- un substrat semiconducteur (110 ; 210 ; 310) en CdₓHg₁₋ₓTe ;
- un revêtement structuré (122 ; 222), recouvrant une face supérieure (11; 311) du substrat semiconducteur, et muni d'au moins une première ouverture traversante (121) ; et
- au moins un plot de contact électrique (171), en métal ;
dans lequel le substrat semiconducteur (110 ; 210 ; 310) comporte, pour chaque pixel :
- une région dopée N;
- une région dopée P (160), formant une jonction PN avec la région dopée N, affleurant la face supérieure (111 ; 311) du substrat semiconducteur, et en contact physique direct avec l'un respectif parmi l'au moins un plot de contact électrique (171) ; et
- un caisson concentré (180), localisé uniquement dans la région dopée P (160) et présentant une concentration moyenne en cadmium supérieure à la concentration moyenne en cadmium dans la région dopée N ;
**caractérisé en ce que** dans chaque pixel :
- la région dopée P (160) comporte une base (163) qui s'étend à partir de la face supérieure (111; 311) du substrat semiconducteur et au moins une protubérance (164) qui fait saillie depuis la base dans la direction opposée à ladite face supérieure du substrat semiconducteur ;
- le caisson concentré (180) présente un gradient de concentration en cadmium, définissant dans ce dernier au moins une zone de gap intermédiaire (181) et au moins une zone fort gap (182), avec la zone de gap intermédiaire (181) qui présente une concentration moyenne en cadmium strictement inférieure à la concentration moyenne en cadmium dans la zone fort gap (182) ; et
- chaque zone de gap intermédiaire (181) est en contact physique direct avec ledit plot de contact électrique respectif (171), au niveau d'au moins une première ouverture traversante (121) correspondante du revêtement structuré (122 ; 222).

11. Dispositif de photo-détection (100) selon la revendication 10, **caractérisé en ce que** chaque pixel comporte une unique zone de gap intermédiaire (181) et une unique zone fort gap (182), avec la zone de gap intermédiaire (181) agencée concentrique avec la région dopée P (160) et entourée par la zone fort gap (182).

## Patentansprüche

1. Verfahren zur Herstellung einer Photodetektionsvorrichtung (100), das die folgenden Schritte beinhaltet:
a) Abscheidung, auf einem Halbleitersubstrat (110; 210; 310) aus CdₓHg₁₋ₓTe, einer Quellbeschichtung (120), die mindestens eine cadmiumreiche Schicht beinhaltet, die eine höhere mittlere Cadmiumkonzentration als das Halbleitersubstrat hat, wobei die cadmiumreiche Schicht in direktem physischem Kontakt mit einer oberen Fläche (111; 311) des Halbleitersubstrats steht;
b) Realisierung einer ersten Ätzmaske (140; 240), die die Quellbeschichtung auf der dem Halbleitersubstrat gegenüberliegenden Seite überlagert;
c) ersten Ätzschritt, um die Quellbeschichtung (120) durch die erste Ätzmaske (140; 240) zu ätzen und dadurch mindestens eine erste durchgehende Öffnung (121) in der Quellbeschichtung zu bilden, wobei die Quellbeschichtung, die mit der mindestens einen ersten durchgehenden Öffnung ausgestattet ist, als strukturierte Beschichtung (122; 222; 422) bezeichnet wird;
d) zweiten Ätzschritt, um mindestens eine zweite durchgehende Öffnung (141; 291) in einer Struktur (140; 290) zu erweitern, die die strukturierte Beschichtung (122; 222) beim Abschluss des ersten Ätzschritts überragt, und um so eine zweite Ätzmaske (150; 250; 450) zu bilden;
e) Injektion von Akzeptor-Dotierungselementen in das Halbleitersubstrat (110; 210; 310) durch die durchgehenden Öffnungen (151) der zweiten Ätzmaske (150; 250; 450), wobei die Akzeptor-Dotierungselemente die strukturierte Beschichtung (122; 222) lokal durchdringen;
f) Aktivierung und Diffusion der Akzeptor-Dotierungselemente, um mindestens einen p-dotierten Bereich (160) im Halbleitersubstrat zu bilden;
g) selektives Austauschdiffusionsglühen des Cadmiums, durchgeführt nach Schritt f) oder mindestens teilweise gleichzeitig mit Schritt f), während dem Cadmiumatome von der strukturierten Beschichtung (122; 222) zum mindestens einen P-dotierten Bereich (160) diffundieren, so dass in jedem P-dotierten Bereich ein konzentrierter Block (180) mit mindestens einer mittigen Spaltzone (181) und mindestens einer hohen Spaltzone (182) gebildet wird, wobei die mittige Spaltzone (181) eine mittlere Cadmiumkonzentration aufweist, die streng unter der mittleren Cadmiumkonzentration in der hohen Spaltzone (182) liegt; und
h) Abscheidung einer Metallschicht (170), die mit dem Halbleitersubstrat (110; 210; 310) in Kontakt kommt, an der mindestens einen ersten durchgehenden Öffnung (121) in der strukturierten Beschichtung (122; 222), um mindestens ein elektrisches Kontaktpad (171) zu bilden.

2. Verfahren nach Anspruch 1, **dadurch gekennzeichnet, dass**:
- in Schritt b) die erste Ätzmaske (140) direkt auf der Quellbeschichtung (120) realisiert wird, auf der dem Halbleitersubstrat (110) gegenüberliegenden Seite; und
- in Schritt d) die Struktur, die die strukturierte Beschichtung (122) beim Abschluss des ersten Ätzschritts überragt, aus der ersten Ätzmaske (140) besteht, so dass die zweite Ätzmaske (150) im Material der ersten Ätzmaske gebildet ist.

3. Verfahren nach Anspruch 2, **dadurch gekennzeichnet, dass** eine Dicke der ersten Ätzmaske (140) so ausgelegt ist, dass die zweite Ätzmaske (150) beim Abschluss von Schritt d) eine Dicke (e₁) aufweist, die größer oder gleich einer Grenzschwelle ist, unterhalb derer, in Schritt e), die Akzeptor-Dotierungselemente die zweite Ätzmaske (150) zwischen deren durchgehenden Öffnungen durchdringen würden.

4. Verfahren nach Anspruch 1, **dadurch gekennzeichnet, dass** es ferner zwischen den Schritten a) und b) einen Schritt der Abscheidung einer Opferschicht (290) auf der Quellbeschichtung beinhaltet, auf der dem Halbleitersubstrat (210) gegenüberliegenden Seite, und dass:
- in Schritt b) die erste Ätzmaske (240) auf der Opferschicht (290) auf der dem Halbleitersubstrat (210) gegenüberliegenden Seite realisiert wird;
- in Schritt c) die Opferschicht (290) zusammen mit der Quellbeschichtung durch die erste Ätzmaske (240) geätzt wird;
- in Schritt d) die Struktur, die die strukturierte Beschichtung (222) überragt, beim Abschluss des ersten Ätzschritts, aus der geätzten Opferschicht besteht, so dass die zweite Ätzmaske (250) im Material der Opferschicht gebildet ist.

5. Verfahren nach Anspruch 4, **dadurch gekennzeichnet, dass** es ferner einen Schritt der Entfernung der ersten Ätzmaske (140; 240) beinhaltet, der nach Schritt d) und vor Schritt e) durchgeführt wird.

6. Verfahren nach einem der Ansprüche 1 bis 5, **dadurch gekennzeichnet, dass** in Schritt d) eine Ätztiefe, in radialen Richtungen parallel zur Ebene des Halbleitersubstrats, größer oder gleich 1 µm ist.

7. Verfahren nach einem der Ansprüche 1 bis 6, **dadurch gekennzeichnet, dass** es ferner einen Schritt der Füllung von Quecksilberleerstellen beinhaltet, um im Halbleitersubstrat (110; 210; 310) einen N-dotierten Bereich zu bilden, der mit jedem P-dotierten Bereich (160) einen jeweiligen P-N-Übergang bildet.

8. Verfahren nach einem der Ansprüche 1 bis 7, **dadurch gekennzeichnet, dass** beim Abschluss von Schritt d) die zweite Ätzmaske (150; 250) so viele durchgehende Öffnungen beinhaltet wie die erste Ätzmaske (140; 240).

9. Verfahren nach einem der Ansprüche 1 bis 7, **dadurch gekennzeichnet, dass** in Schritt d) mehrere zweite durchgehende Öffnungen der Struktur zu einer einzigen durchgehenden Öffnung verbunden werden, so dass beim Abschluss von Schritt d) die zweite Ätzmaske (450) weniger durchgehende Öffnungen beinhaltet als die erste Ätzmaske.

10. Photodetektionsvorrichtung (100) mit mindestens einem Pixel, die unter Verwendung eines Verfahrens nach einem der Ansprüche 1 bis 9 erhalten wurde, und beinhaltet:
- ein Halbleitersubstrat (110; 210; 310) aus CdₓHg₁₋ₓTe;
- eine strukturierte Beschichtung (122; 222), die eine obere Fläche (11; 311) des Halbleitersubstrats bedeckt und mit mindestens einer ersten durchgehenden Öffnung (121) ausgestattet ist; und
- mindestens ein elektrisches Kontaktpad (171) aus Metall;
wobei das Halbleitersubstrat (110; 210; 310) für jedes Pixel beinhaltet:
- einen N-dotierten Bereich;
- einen P-dotierten Bereich (160), der einen P-N-Übergang mit dem N-dotierten Bereich bildet, bündig mit der oberen Fläche (111; 311) des Halbleitersubstrats, und in direktem physischen Kontakt mit dem jeweiligen unter dem mindestens einen elektrischen Kontaktpad (171); und
- ein konzentrierter Block (180), der nur im P-dotierten Bereich (160) lokalisiert ist, und eine mittlere Cadmiumkonzentration aufweist, die über der mittleren Cadmiumkonzentration im N-dotierten Bereich liegt;
**dadurch gekennzeichnet, dass** in jedem Pixel:
- der P-dotierte Bereich (160) eine Basis (163) beinhaltet, die sich von der oberen Fläche (111; 311) des Halbleitersubstrats erstreckt, und mindestens einen Vorsprung (164), der von der Basis in entgegengesetzter Richtung zur oberen Fläche des Halbleitersubstrats vorsteht;
- der konzentrierte Block (180) einen Gradienten der Cadmiumkonzentration aufweist, der in diesem mindestens eine mittige Spaltzone (181) und mindestens eine hohe Spaltzone (182) definiert, wobei die mittige Spaltzone (181) eine mittlere Cadmiumkonzentration aufweist, die streng unter der mittleren Cadmiumkonzentration in der hohen Spaltzone (182) liegt; und
- jede mittige Spaltzone (181) in direktem physischen Kontakt mit dem jeweiligen elektrischen Kontaktpad (171) steht, an mindestens einer entsprechenden ersten durchgehenden Öffnung (121) der strukturierten Beschichtung (122; 222).

11. Photodetektionsvorrichtung (100) nach Anspruch 10, **dadurch gekennzeichnet, dass** jedes Pixel eine einzige mittige Spaltzone (181) und eine einzige hohe Spaltzone (182) beinhaltet, wobei die mittige Spaltzone (181) konzentrisch mit dem P-dotierten Bereich (160) angeordnet und von der hohen Spaltzone (182) umgeben ist.

## Claims

1. A method for manufacturing a photodetection device (100), which includes the following steps:
a) depositing, onto a semiconductor substrate (110; 210; 310) of CdxHg₁₋ₓTe, a source coating (120) which includes at least one cadmium-rich layer having a higher average cadmium concentration than the semiconductor substrate, with the cadmium-rich layer being in direct physical contact with an upper face (111; 311) of the semiconductor substrate;
b) making a first etch mask (140; 240), superimposed on the source coating on the side opposite to the semiconductor substrate;
c) first etching step, to etch the source coating (120) across the first etch mask (140; 240) and thus forming at least one first through opening (121) in the source coating, the source coating provided with the at least one first through opening being called a structured coating (122; 222; 422);
d) second etching step, to widen at least one second through opening (141; 291) in a structure (140; 290) on top of the structured coating (122; 222) at the end of the first etching step, and thus to form a second etch mask (150; 250; 450);
e) injecting acceptor dopant elements into the semiconductor substrate (110; 210; 310), across through openings (151) in the second etch mask (150; 250; 450), with the acceptor dopant elements passing locally through the structured coating (122; 222);
f) activating and diffusing the acceptor dopant elements to form at least one P-doped region (160) in the semiconductor substrate;
g) selectively interdiffusion annealing the cadmium, implemented after step f) or at least partly simultaneously with step f), during which cadmium atoms diffuse from the structured coating (122; 222) towards the at least one P-doped region (160), so as to form, in each P-doped region, a concentrated case (180) with at least one intermediate-gap zone (181) and at least one high-gap zone (182), where the intermediate-gap zone (181) has an average cadmium concentration strictly lower than the average cadmium concentration in the high-gap zone (182); and
h) depositing a metal layer (170) contacting the semiconductor substrate (110; 210; 310) at the at least one first through opening (121) in the structured coating (122; 222), to form at least one electrical contact pad (171).

2. The method according to claim 1, **characterised in that**:
- in step b), the first etch mask (140) is directly made on the source coating (120), on the side opposite to the semiconductor substrate (110); and
- in step d), the structure on top of the structured coating (122) at the end of the first etching step consists of the first etch mask (140), so that the second etch mask (150) is formed in the material of the first etch mask.

3. The method according to claim 2, **characterised in that** a thickness of the first etch mask (140) is adapted so that, at the end of step d), the second etch mask (150) has a thickness (e₁) greater than or equal to a limit threshold below which, in step e), the acceptor dopant elements would pass through the second etch mask (150) between the through openings thereof.

4. The method according to claim 1, **characterised in that** it further includes, between steps a) and b), a step of depositing a sacrificial layer (290) onto the source coating, on the side opposite to the semiconductor substrate (210), and **in that**:
- in step b), the first etch mask (240) is made on the sacrificial layer (290), on the side opposite to the semiconductor substrate (210);
- in step c), the sacrificial layer (290) is etched together with the source coating, through the first etch mask (240);
- in step d), the structure on top of the structured coating (222) at the end of the first etching step is formed by the sacrificial layer etched, so that the second etch mask (250) is formed in the material of the sacrificial layer.

5. The method according to claim 4, **characterised in that** it further includes a step of removing the first etch mask (140; 240), implemented after step d) and before step e).

6. The method according to any one of claims 1 to 5, **characterised in that** in step d), an etching depth, in radial directions parallel to the plane of the semiconductor substrate, is greater than or equal to 1 µm.

7. The method according to any one of claims 1 to 6, **characterised in that** it further includes a step of filling mercury vacancies, to form, in the semiconductor substrate (110; 210; 310), an N-doped region forming a respective PN junction with each P-doped region (160).

8. The method according to any one of claims 1 to 7, **characterised in that**, at the end of step d), the second etch mask (150; 250) includes as many through opening(s) as the first etch mask (140; 240).

9. The method according to any one of claims 1 to 7, **characterised in that**, in step d), a plurality of second through openings in the structure are brought together so as to form only a single through opening, so that, at the end of step d), the second etch mask (450) includes fewer through openings than the first etch mask.

10. A photo-detection device (100) with at least one pixel, obtained using a method according to any one of claims 1 to 9, and including:
- a semiconductor substrate (110; 210; 310) of CdₓHg₁₋ₓTe;
- a structured coating (122; 222) covering an upper face (11; 311) of the semiconductor substrate, and provided with at least one first through opening (121); and
- at least one electrical contact pad (171) of metal;
wherein the semiconductor substrate (110; 210; 310) includes, for each pixel:
- an N-doped region;
- a P-doped region (160), forming a PN junction with the N-doped region, flush with the upper face (111; 311) of the semiconductor substrate, and in direct physical contact with a respective one of the at least one electrical contact pad (171); and
- a concentrated case (180), located only in the P-doped region (160) and having an average cadmium concentration greater than the average cadmium concentration in the N-doped region;
**characterised in that** in each pixel:
- the P-doped region (160) includes a base (163) which extends from the upper face (111; 311) of the semiconductor substrate and at least one protrusion (164) which projects from the base in the opposite direction to said upper face of the semiconductor substrate;
- the concentrated case (180) has a cadmium concentration gradient, defining at least one intermediate-gap zone (181) and at least one high-gap zone (182) therein, with the intermediate-gap zone (181) having an average cadmium concentration strictly lower than the average cadmium concentration in the high-gap zone (182); and
- each intermediate-gap zone (181) is in direct physical contact with said respective electrical contact pad (171), at at least one corresponding first through opening (121) of the structured coating (122; 222).

11. The photodetection device (100) according to claim 10, **characterised in that** each pixel includes a single intermediate-gap zone (181) and a single high-gap zone (182), with the intermediate-gap zone (181) arranged concentric with the P-doped region (160) and surrounded by the high-gap zone (182).
